# EUROPEAN PATENT SPECIFICATION

(11) **EP 0 392 461 B1**
(45) Date of publication and mention of the grant of the patent: **10.08.1994**
(21) Application number: 90106850.2
(22) Date of filing: 10.04.1990
(51) Int. Cl.: H01L 29/16, H01L 23/29, H01C 7/04

(54) **Thermistor made of diamond**
Thermistor, der aus Diamant hergestellt ist
Thermistance préparé à partir de diamant

(30) Priority: 12.04.1989 JP 93825/89
(43) Date of publication of application: 17.10.1990
(73) Proprietor: SUMITOMO ELECTRIC INDUSTRIES, LTD., Osaka-shi, Osaka 541 (JP)
(72) Inventor: Nakahata, Hideaki, c/o Itami Works, 1-1 Koyakita 1-chome Itami-shi Hyogo-ken (JP); Imai, Takahiro, c/o Itami Works, 1-1 Koyakita 1-chome Itami-shi Hyogo-ken (JP); Fujimori, Naoji, c/o Itami Works, 1-1 Koyakita 1-chome Itami-shi Hyogo-ken (JP)
(74) Representative: Herrmann-Trentepohl, Werner, Dipl.-Ing.

(56) References cited:
- US-A- 3 435 399
- PATENT ABSTRACTS OF JAPAN vol. 7, no. 255 (E-210)(1400) 12 October 1983 ; & JP-A-58 141 572
- JOURNAL OF CRYSTAL GROWTH, vol. 52, 1981, Amsterdam, NL, pp. 219-226; B.V. Spitsyn et al : "Vapor Growth of Diamond on Diamond and Other Surfaces"
- SOVIET PHYSICS SEMICONDUCTORS, vol. 19, no. 8, August 1985, New York, US, pp. 829-841 ; V.K. Bazhenov et al. : "Synthetic Diamonds in Electronics (review)"
- Proceedings of International Electron Device Meeting, San Fransico, CA, Dec 11-14, 1988, IEEE, New York, USA, pp. 626-629 ; G.Sh. Gildenblat et al. : "Schottky Diodes With Thin Film Diamond Base".

## Description

### BACKGROUND OF THE INVENTION

### Field of the Invention

The present invention relates to a thermistor which is excellent in heat resistance and environment resistance, and more particularly, it relates to a thermistor which is prepared from diamond.

### Description of the Background Art

A semiconductor material for a semiconductor device is typically prepared from silicon. In order to protect such a silicon semiconductor element, an insulating protective film is deposited on its surface. The insulating protective film is typically formed of silicon oxide, phosphorus glass or the like.

Such silicon oxide or phosphorus glass, generally employed as a material for the insulating protective film, is inferior in heat conductivity. Thus, the characteristics of the silicon semiconductor element may be deteriorated by a temperature rise during employment. Further, a semiconductor device formed by employing such a silicon semiconductor element cannot be used under a high temperature, due to the characteristics of silicon. In addition, it is impossible to prevent radioactive rays by the insulating protective film of silicon oxide or phosphorus glass. Thus, the conventional semiconductor device of the aforementioned type cannot be used in an atmosphere which is exposed to radioactive rays.

A vapor-phase synthesizing method for a diamond film has been recently established, and effective use of such a diamond film is studied nowadays. It is possible to synthesize a diamond film having high insulativity, which may be applicable to an insulating protective film for a silicon semiconductor element or the like. For example, a gazette of Japanese Patent Laying-Open No. 58-145134(1983) discloses a semiconductor device which is formed by covering the surface of a silicon semiconductor element with an insulating protective film of diamond.

However, such a semiconductor device, which is formed by covering the surface of a silicon semiconductor element with an insulating protective film of diamond, has the following problems: First, distortion or stress may appear in the interface between the silicon semiconductor element and the insulating protective film of diamond due to a temperature change since silicon is extremely different in thermal expansion coefficient from diamond. Second, the silicon semiconductor element and the diamond insulating protective film are inferior in adhesion since silicon and diamond are dissimilar materials. Third, it is impossible to use the semiconductor device under a high temperature of hundreds of degrees, due to the characteristics of silicon itself.

Diamond has various interesting characteristics such as high chemical stability, a large electrical band gap, high carrier mobility, a small dielectric constant and the like. In relation to such characteristics of diamond, study has been made to develop a semiconductor element which is formed by employing diamond as a semiconductor material. Such a diamond semiconductor material can be used under a high temperature exceeding 500°C, while the same exhibits stable characteristics against radioactive rays. Further, the diamond semiconductor material exhibits tolerance under harsh environment such as an acid or alkaline atmosphere.

In the process of study for applying diamond to a heat-conductive semiconductor material, the following problem has been recognized: The resistance value of a diamond semiconductor film which is formed by a vapor-phase synthesizing method is gradually changed when the same is placed in a high-temperature atmosphere of 600°C, for example. Such change of the resistance value may result from reaction of the diamond semiconductor film with oxygen. If crystal defects are caused in vapor phase synthesis of the diamond semiconductor film, for example, etching may gradually progress from the crystal defect portions, due to reaction with oxygen. Or, the level of an impurity doped in the film may be gradually compensated from the portions of the crystal defects by reaction with oxygen.

In US-A-3 435 399, a thermistor made of diamond is described where the above problem is solved by encasing the thermistor in a glass envelope which also seals off an inert gas for the diamond.

### SUMMARY OF THE INVENTION

The present invention has been proposed to solve the aforementioned problem, and an object thereof is to provide a thermistor which exhibits stable operating characteristics even if the same is used under a high temperature of hundreds of degrees.

The present invention is directed to a thermistor which is formed by covering the surface of the thermistor, prepared from a diamond semiconductor material, with an insulating protective film of diamond as defined in claim 1.

According to the present invention, the surface of a thyristor whose semiconductor layer is made of diamond is covered with an insulating protective film of diamond which is excellent in insulativity (the properties of the insulating protective film are defined further on). Thus, it is possible to effectively prevent the diamond semiconductor layer from deterioration of characteristics. Even if the semiconductor device is placed under a high temperature of at least 300°C or 500°C in an oxygen atmosphere, the semiconductor diamond layer is not directly exposed to the oxygen atmosphere. Therefore, no resistance change is caused by reaction with oxygen, and the characteristics of the semiconductor diamond layer can be stably maintained. Further, the semiconductor layer is not etched by oxygen. Thus, according to the present invention, it is possible to improve durability of the semiconductor element against a high temperature.

If crystal defects are present in the insulating protective film of diamond, oxygen may gradually etch the film from the defective portions. However, the speed of progress of such etching is greatly reduced when the insulating protective film is prepared from a diamond material which is excellent in crystallinity. Consequently, it takes an impractically long time before the semiconductor diamond layer is partially exposed to the atmosphere by such etching of the diamond insulating protective film. In consideration of these circumstances, it is necessary to improve crystallinity of the diamond material for the insulating protective film in order to attain a good effect of protecting the diamond semiconductor layer against a high temperature.

The inventive thermistor can be effectively used in harsh environment such as an engine room of an automobile, a nuclear reactor, an artificial satellite or the like since the same is superior in heat resistance, radiation resistance and durability against a high temperature to the conventional semiconductor device.

The insulating protective diamond film can be easily grown on the semiconductor diamond layer, as a matter of course. Since both the semiconductor layer and the insulating protective film formed thereon are made of diamond, no difference is caused in thermal expansion coefficient and extremely good adhesion can be attained. Therefore, even if the semiconductor device is subjected to a significant temperature change of 20°C to 500°C, for example, no distortion nor stress is caused in the interface between the semiconductor layer and the insulating protective film while no cracking nor separation takes place in the insulating protective film. Further, the amount of impurity ions entering the interface or the semiconductor diamond layer is reduced as compared with an insulating protective film which is prepared from a material other than diamond, such as silicon oxide, for example, to advantageously facilitate the operation of the semiconductor layer.

In order to maintain good insulativity, the thickness of the insulating protective diamond film is made 0.01 to 10 µm in general. The resistivity of the insulating protective diamond film is preferably made higher by at least two orders of magnitude than that of the diamond semiconductor layer, so that a leakage current passing through the insulating protective diamond film can be suppressed to not more than 1 %. In a semiconductor device which must suppress such a leakage current to not more than 0.1 %, the resistivity of the insulating protective diamond film is preferably made higher by at least three orders of magnitude than that of the diamond semiconductor layer. In another point of view, the resistivity of the insulating protective diamond film is preferably at least 10⁸ Ω·cm at the room temperature.

Insulativity of the insulating protective diamond film can be determined through Raman spectroscopic analysis. A diamond film having good insulativity is excellent in crystallinity, and includes no diamond-type carbon film. Such a diamond film having good crystallinity satisfies the following conditions: When Raman spectroscopic analysis is made on the overall portion of the insulating protective diamond film through a laser beam having a spot diameter of not more than 2 µm, Raman scattering light of diamond is observed in a Raman shift at 1333 ± 5 cm⁻¹, while the maximum intensity of Raman scattering light within those of graphite, amorphous carbon and the like appearing at 1150 cm⁻¹ to 1750 cm⁻¹ is not more than 1/5, more preferably not more than 1/20 the intensity of the Raman scattering light of diamond.

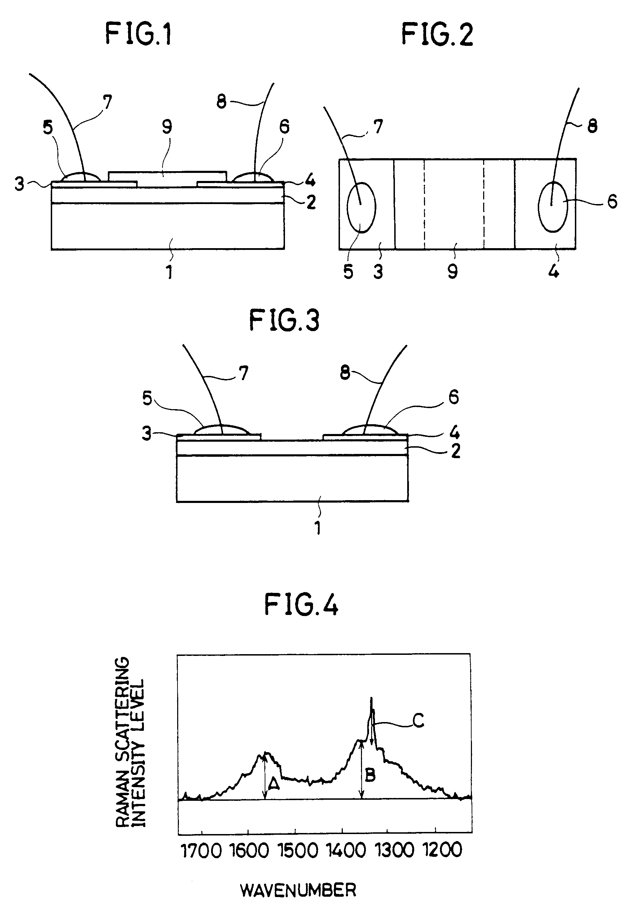

Fig. 4 illustrates Raman scattering spectra. In this figure, the horizontal line represents wavenumbers, and the vertical line represents measured levels of Raman scattering intensity. Referring to Fig. 4, a point indicating a Raman scattering intensity level measured at 1150 cm⁻¹ is connected with a point indicating a Raman scattering intensity level measured at 1750 cm⁻¹ by a straight line to regard the portion located under the straight line as the background. Raman scattering intensity is represented by the level of a portion located above the straight line within the peak of each Raman scattering spectrum. If the peak of a Raman scattering spectrum overlaps with another peak, Raman scattering intensity is evaluated by subtracting the overlapping value.

In the Raman scattering spectra shown in Fig. 4, Raman scattering light of diamond is observed at a wavenumber of 1333 cm⁻¹. Symbol C represents the intensity of the Raman scattering light of diamond. Raman scattering light of amorphous-type carbon is observed at a wavenumber of 1370 cm⁻¹. Symbol B represents the intensity of the Raman scattering light of amorphous-type carbon. Another Raman scattering light of amorphous-type carbon is observed at a wavenumber of 1555 cm⁻¹. Symbol A represents the intensity of this Raman scattering light of amorphous-type carbon. In the Raman scattering spectra shown in Fig. 4, the Raman scattering intensity B of amorphous-type carbon is at the maximum level within those of Raman scattering in the range of 1150 cm⁻¹ to 1750 cm⁻¹, except for the Raman scattering intensity C of diamond. In order to obtain a diamond film having good insulativity, it is necessary to make a ratio B/C preferably not more than 1/5, more preferably not more than 1/20.

In the inventive semiconductor device, it is difficult to directly make Raman spectroscopic analysis only on the insulating protective diamond film, which is stacked on the semiconductor diamond layer. However, it is possible to leave only the insulating protective diamond film which is provided on the surface of the semiconductor device by polishing its back surface and removing the back of only a target portion for analysis by ion beam etching. The insulating protective diamond film thus left may be subjected to Raman spectroscopic analysis.

Crystallinity of the diamond film can be easily and quickly measured through a Raman spectroscopic process of a multi-channel system, although the same can alternatively be evaluated by the peak half width of a diffraction pattern through X-ray diffraction or the like.

A polycrystalline diamond film or a diamond-type carbon film containing a large amount of defective portions, graphite components or amorphous components does not satisfy the aforementioned conditions. However, such a film can also be applied to the insulating protective film in order to protect the diamond semiconductor layer against chemical pollusion, which exerts a bad influence on the layer, if the semiconductor device is used under a low temperature of not more than 300°C. When the diamond or diamond-type carbon film having inferior crystallinity is used under a high temperature exceeding 300°C, however, etching abruptly progresses from graphite regions or defective portions, for example, by reaction with oxygen to expose the diamond semiconductor layer to the atmosphere within a short period. Therefore, the diamond film having inferior crystallinity cannot be applied to the insulating protective film for a semiconductor device which is used under a high temperature exceeding 300°C.

For example, a polycrystalline diamond film which is formed by a microwave plasma CVD process under conditions of a component ratio CH₄/H₂ of a raw material gas of 3 %, microwave power of 350 W and a reaction pressure of 40 Torr is an aggregate of diamond grown particles of (100) plane orientation. When this polycrystalline diamond film is subjected to Raman spectroscopic analysis, only a peak of diamond at 1333 cm⁻¹ appears in portions of the diamond particles of (100) plane orientation, to exhibit excellent crystallinity. In clearance portions between the particles, however, Raman scattering of graphite or amorphous carbon whose intensity is 1/10 to 1/2 that of the Raman scattering at 1333 cm⁻¹ or higher appears to exhibit inferior crystallinity. When such a film is placed under a high temperature exceeding 300°C in the atmosphere, etching progresses from grain boundary portions, to hinder the effect of the protective film. Thus, the diamond film which is applicable to the insulating protective film according to the present invention must be excellent in crystallinity entirely over its portion.

The insulating protective diamond film can be formed by a vapor-phase synthesizing method. A diamond film having good crystallinity can be obtained by any one of existing vapor-phase synthesizing methods such as (1) a method of activating a raw material gas by heating a thermoionic emission material, (2) a method of utilizing a discharge by a direct current, a high frequency or a microwave electric field, (3) a method of utilizing ion impact, (4) a method of burning a raw material gas, and the like. When a base material is prepared from monocrystal diamond, a semiconductor diamond film grown thereon becomes an epitaxial monocrystal film, while an insulating protective diamond film further grown thereon also becomes an epitaxial monocrystal film.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a sectional view showing a thermistor according to an embodiment of the inventive semiconductor device;
Fig. 2 is a plan view of the thermistor shown in Fig. 1;
Fig. 3 is a sectional view showing a thermistor having no insulating protective diamond film; and
Fig. 4 illustrates Raman scattering spectra.

### DESCRIPTION OF THE PREFERRED EMBODIMENTS

Fig. 1 is a sectional view showing a thermistor according to an embodiment of the inventive semiconductor device, and Fig. 2 is a plan view thereof. A B-doped semiconductor diamond polycrystalline film 2 is formed on an Si₃N₄ substrate 1. A pair of ohmic electrodes 3 and 4 are formed on the semiconductor diamond polycrystalline film 2. A lead wire 7 is connected to the electrode 3 through heat-resistant silver paste 5, for example. Another lead wire 8 is also connected to the other electrode 4 through heat-resistant silver paste 6. The surface of the B-doped semiconductor diamond polycrystalline film 2 is covered with a non-doped insulative diamond polycrystalline film 9. The thermistor shown in Figs. 1 and 2 can be stably used in a temperature range of -50°C to 600°C.

### Example

Ten samples of the thermistor shown in Fig. 1 were prepared. In more concrete terms, semiconductor diamond films 2 of 2 µm in thickness were formed entirely over the surfaces of Si₃N₄ substrates of 1.5 x 3.8 x 0.2 mm under conditions of a composition ratio CH₄/H₂ of a raw material gas of 1/200, a composition ratio B₂H₆/CH₄ of a dopant gas of 100 ppm, microwave power of 400 W and a reaction pressure of 40 Torr through a microwave plasma CVD process. Three-layer electrodes of Ti, Mo and Au were formed on the semiconductor diamond films 2 by electron beam deposition, to define pairs of ohmic electrodes 3 and 4.

Then, ten types of insulative polycrystalline diamond films 9 of 1 µm in thickness, which were different in crystallinity from each other, were formed on the semiconductor diamond films 2 by a microwave plasma CVD process. Treatment conditions for forming the ten types of insulative polycrystalline diamond films were as follows:
(1) Sample 1
   Microwave Power: 400 W
   Reaction Pressure: 40 Torr
   Raw Material Gas: CH₄/H₂ = 0.5 %
(2) Sample 2
   Microwave Power: 400 W
   Reaction Pressure: 40 Torr
   Raw Material Gas: CH₄/H₂ = 1.5 %
   O₂/H₂ = 0.5 %
(3) Sample 3
   Microwave Power: 400 W
   Reaction Pressure: 40 Torr
   Raw Material Gas: CH₄/H₂ = 1.5 %
(4) Sample 4
   Microwave Power: 400 W
   Reaction Pressure: 40 Torr
   Raw Material Gas: CH₄/H₂ = 2 %
   O₂/H₂ = 0.5 %
(5) Sample 5
   Microwave Power: 400 W
   Reaction Pressure: 40 Torr
   Raw Material Gas: CH₄/H₂ = 3 %
   O₂/H₂ = 0.5 %
(6) Sample 6
   Microwave Power: 400 W
   Reaction Pressure: 40 Torr
   Raw Material Gas: CH₄/H₂ = 6 %
   O₂/H₂ = 0.5 %
(7) Sample 7
   Microwave Power: 400 W
   Reaction Pressure: 40 Torr
   Raw Material Gas: CH₄/H₂ = 3 %
(8) Sample 8
   Microwave Power: 400 W
   Reaction Pressure: 40 Torr
   Raw Material Gas: CH₄/H₂ = 4 %
(9) Sample 9
   Microwave Power: 400 W
   Reaction Pressure: 40 Torr
   Raw Material Gas: CH₄/H₂ = 5 %
(10) Sample 10
   Microwave Power: 400 W
   Reaction Pressure: 40 Torr
   Raw Material Gas: CH₄/H₂ = 6 %
With respect to each of these samples 1 to 10, Ni lead wires 7 and 8 of 0.1 mmφ were fixed to the electrodes 3 and 4 through heat-resistant silver paste members 5 and 6 respectively, to prepare a diamond thermistor having the structure shown in Fig. 1.

Fig. 3 shows a thermistor which was prepared as a comparative sample 11. The thermistor shown in Fig. 3 has no insulative polycrystalline diamond film 9 shown in Fig. 1. Other structure of this thermistor is identical to that shown in Fig. 1.

As to the thermistors of the samples 1 to 11, changes of resistance values were measured in the atmosphere at a temperature of 500°C over 100 hours.

Separately from those subjected to measurement of resistance changes, samples of the same types were prepared for Raman spectroscopic analysis of the insulating protective films. In each sample, ion beam etching was applied from the back surface to a central portion to remove the Si₃N₄ substrate and the B-doped semiconductor diamond film so that only a portion of the insulating protective diamond film of 30 µm in diameter was left on the central portion.

The results of Raman spectroscopic analysis and durability measurement of resistance values are described below. As to each sample, "P" represents the result of the Raman spectroscopic analysis, i.e., the ratio of the maximum intensity of Raman shifts appearing in a range of 1150 cm⁻¹ to 1750 cm⁻¹ to the intensity of a Raman shift at 1333 ± 5 cm⁻¹, and "Q" represents a resistance change appearing at a temperature of 500°C after a lapse of 100 hours.
Sample 1
   "P": 0
   "Q": increased by 0.5 %
Sample 2
   "P": 0.01
   "Q": increased by 0.5 %
Sample 3
   "P": 0.05
   "Q": increased by 0.5 %
Sample 4
   "P": 0.1
   "Q": increased by 1.1 %
Sample 5
   "P": 0.2
   "Q": increased by 0.9 %
Sample 6
   "P": 0.3
   "Q": increased by 30 %
Sample 7
   "P": 0.5
   "Q": increased by 25 %
Sample 8
   "P": 1.0
   "Q": increased by 28 %
Sample 9
   "P": 2.0
   "Q": increased by 39 %
Sample 10
   "P": 3.0
   "Q": increased by 39 %
Comparative Sample 11
   (provided with no insulating protective diamond film)
   "Q": increased by 40 %
Although the present invention has been described and illustrated in detail, it is clearly understood that the same is by way of illustration and example only and is not to be taken by way of limitation, the scope of the present invention being limited only by the terms of the appended claims.

## Claims

1. A thermistor comprising:
a semiconductor diamond film (2);
a pair of electrodes (3, 4) formed on said semiconductor diamond film to be spaced apart from each other;
a pair of lead wires (7, 8) connected to said pair of electrodes; and
an insulating diamond film (9) for covering the surface of said semiconductor diamond film located between said pair of electrodes (3, 4), wherein
Raman scattering light of diamond is observed at a wavenumber of 1333 ± 5 cm ⁻¹ when said insulating protective diamond film is subjected to Raman spectroscopic analysis, and the maximum intensity of Raman scattering light of graphite or amorphous carbon appearing in a range of 1150 cm⁻¹ to 1750 cm⁻¹ is not more than 1/5 the intensity of said Raman scattering light of diamond.

2. The thermistor in accordance with claim 1, wherein the thickness of said insulating protective diamond film is within a range of 0.01 to 10 µm.

3. The thermistor in accordance with claim 1, wherein the resistivity of said insulating protective diamond film is higher by at least two orders of magnitude than that of said semiconductor layer.

4. The thermistor in accordance with claim 1, wherein the resistivity of said insulating protective diamond film is at least 10⁸ Ω·cm at the room temperature.

5. The thermistor in accordance with claim 1, wherein said semiconductor diamond film is a B-doped semiconductor diamond polycrystalline film, and said insulating diamond film is a non-doped insulating diamond polycrystalline film.

## Patentansprüche

1. Ein Thermistor umfassend:
ein Diamanthalbleiterfilm (2);
ein Paar von Elektroden (3,4), welche an dem Diamanthalbleiter-film im Abstand zueinander angeformt sind;
ein Paar von Leitungsdrähten (7,8), welche mit dem Paar von Elektroden verbunden sind; und
einen isolierenden Diamantfilm (9) zum Bedecken der Oberfläche des Diamanthalbleiterfilms, welcher zwischen dem Paar von Elektroden (3,4) angeordnet ist, worin
Raman-Streulicht von Diamant bei einer Wellenzahl von 1333 ± 5 cm⁻¹ beobachtet wird, wenn der isolierende schützende Diamantfilm einer Raman-Spektroskopie-Analyse ausgesetzt wird, und die maximale Intensität des Raman-Streulichtes von Graphit oder amorphen Kohlenstoff, das in einem Bereich von 1150 cm⁻¹ bis 1750 cm⁻¹ auftritt, nicht mehr als 1/5 der Intensität des Raman-Streulichtes von Diamant ist.

2. Der Thermistor gemäß Anspruch 1, worin die Dicke des isolierenden schützenden Diamantfilms innerhalb eines Bereiches von 0,01 bis 10 µm liegt.

3. Der Thermistor gemäß Anspruch 1, worin der Widerstand des isolierenden schützenden Diamantfilms um mindestens 2 Größenordnungen höher ist, als der der Halbleiterschicht.

4. Der Thermistor nach Anspruch 1, worin der Widerstand des isolierenden schützenden Diamantfilms mindestens 10⁸ Ω x cm bei Raumtemperatur beträgt.

5. Der Thermistor nach Anspruch 1, worin der Halbleiterdiamantfilm ein B-dotierter polykristalliner Diamant-halbleiterfilm ist, und der isolierende Diamantfilm ein nicht-dotierter isolierender polykristalliner Diamant-film ist.

## Revendications

1. Thermistance comprenant :
une pellicule au diamant pour semi-conducteurs (2) ;
une paire d'électrodes (3, 4) formées sur cette pellicule au diamant à semi-conducteurs, espacées l'une de l'autre ;
une paire de fils conducteurs (7, 8) raccordés à cette paire d'électrodes ; et
une pellicule au diamant isolante (9) destinée à recouvrir la surface de la pellicule au diamant à semiconducteurs située entre cette paire d'électrodes (3, 4), thermistance dans laquelle
la diffusion Raman du diamant est observée à une répétance ou nombre d'onde de 1333 ± 5 cm ⁻¹ lorsque la pellicule au diamant protectrice isolante est soumise à une analyse spectroscopique Raman, et l'intensité maximum de la diffusion Raman du graphite ou du carbone amorphe apparaissant dans une plage de 1150 cm⁻¹ à 1750 cm⁻¹ n'est pas supérieure à 1/5^{ème} de l'intensité de la diffusion Raman du diamant.

2. Thermistance selon la revendication 1, dans laquelle l'épaisseur de la pellicule au diamant protectrice isolante se situe dans une plage de 0,01 jusqu'à 10 µm.

3. Thermistance selon la revendication 1, dans laquelle la résistivité de la pellicule au diamant protectrice isolante est supérieure d'au moins deux ordres de grandeur par rapport à celle de la couche des semi-conducteurs.

4. Thermistance selon la revendication 1, dans laquelle la résistivité de la pellicule au diamant protectrice isolante est d'au moins 10⁸ Ω·cm à la température ambiante.

5. Thermistance selon la revendication 1, dans laquelle la pellicule au diamant à semi-conducteurs est une pellicule polycristalline au diamant à semi-conducteurs B-dopée, et la pellicule au diamant isolante est une pellicule polycristalline au diamant isolante non dopée.
